(19) **Europäisches Patentamt / European Patent Office / Office européen des brevets**

(11) **EP 3 387 824 B1**

(12) # FASCICULE DE BREVET EUROPEEN

(45) Date de publication et mention
de la délivrance du brevet:
**30.09.2020 Bulletin 2020/40**

(51) Int Cl.:
**H04N 9/07** (2006.01)   **H04N 5/33** (2006.01)
**H04N 9/04** (2006.01)

(21) Numéro de dépôt: **16808629.6**

(22) Date de dépôt: **07.12.2016**

(86) Numéro de dépôt international:
**PCT/EP2016/080139**

(87) Numéro de publication internationale:
**WO 2017/097857 (15.06.2017 Gazette 2017/24)**

(54) **SYSTÈME ET PROCÉDÉ D'ACQUISITION D'IMAGES VISIBLES ET DANS LE PROCHE INFRAROUGE AU MOYEN D'UN CAPTEUR MATRICIEL UNIQUE**

SYSTEM UND VERFAHREN ZUR ERFASSUNG VON SICHTBAREN UND NAHINFRAROT-BILDERN MITTELS EINES EINZIGEN MATRIXSENSORS

SYSTEM AND METHOD FOR ACQUIRING VISIBLE AND NEAR INFRARED IMAGES BY MEANS OF A SINGLE MATRIX SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2015 FR 1502572**

(43) Date de publication de la demande:
**17.10.2018 Bulletin 2018/42**

(73) Titulaire: **Thales**
**92400 Courbevoie (FR)**

(72) Inventeurs:
• **HORAK, Raphaël**
**78995 Elancourt Cedex (FR)**
• **COURCOL, Yves**
**78995 Elancourt Cedex (FR)**
• **PERRUCHOT, Ludovic**
**78995 Elancourt Cedex (FR)**

(74) Mandataire: **Priori, Enrico et al**
**Marks & Clerk France**
**Immeuble "Visium"**
**22, avenue Aristide Briand**
**94117 Arcueil Cedex (FR)**

(56) Documents cités:
**WO-A1-2014/170359     WO-A1-2015/159651**
**US-A1- 2009 285 476     US-A1- 2015 163 418**

• **HERTEL D ET AL: "A low-cost VIS-NIR true color night vision video system based on a wide dynamic range CMOS imager", INTELLIGENT VEHICLES SYMPOSIUM, 2009 IEEE, IEEE, PISCATAWAY, NJ, USA, 3 juin 2009 (2009-06-03), pages 273-278, XP031489853, ISBN: 978-1-4244-3503-6 cité dans la demande**

EP 3 387 824 B1

Printed by Jouve, 75001 PARIS (FR)

## Description

L'invention porte sur un système d'acquisition d'images visibles et dans le proche infrarouge, sur une caméra bi-spectrale visible - proche infrarouge comprenant un tel système et sur un procédé d'acquisition simultanée d'images en couleurs et dans le proche infrarouge par utilisation d'une telle caméra.

Le « proche infrarouge » (« PIR » ou « NIR », acronyme de l'expression anglaise « Near InfraRed ») correspond à la bande spectrale 700 - 1100 nm, tandis que la lumière visible s'étend entre 350 et 700 nm. Parfois on considère que le proche infrarouge démarre à 800 nm, la bande intermédiaire 700 - 800 nm étant éliminée à l'aide d'un filtre optique.

L'invention peut être appliquée aussi bien dans les secteurs de la défense et de la sécurité (par exemple pour la vision nocturne) que dans l'électronique grand public.

De manière conventionnelle des images en lumière visible (ci-après appelées « images visibles » par souci de concision), généralement en couleurs, et des images dans le proche infrarouge sont acquises de manière indépendante au moyen de deux capteurs matriciels distincts. Afin de réduire l'encombrement, ces deux capteurs peuvent être associés à un système optique formateur d'images unique par l'intermédiaire d'une lame séparatrice dichroïque, de manière à former une caméra bi-spectrale.

Une telle configuration présente un certain nombre d'inconvénients. Premièrement, l'utilisation de deux capteurs indépendants et d'une lame séparatrice augmente le coût, l'encombrement, la consommation électrique et le poids d'une caméra bi-spectrale, ce qui est surtout problématique dans les applications embarquées, par exemple aéroportées. En outre le système optique doit être spécialement adapté pour cette application, ce qui limite les possibilités d'utilisation d'optiques du commerce, augmentant encore plus les coûts.

Il a également été proposé, essentiellement dans des travaux de type académique, d'utiliser un seul capteur matriciel pour l'acquisition des images visibles et dans le proche infrarouge. En effet, les capteurs en silicium couramment utilisés dans les caméras numériques présentent une sensibilité qui s'étend du visible jusqu'au proche infrarouge ; de ce fait, les caméras destinées à opérer uniquement dans le visible sont équipées d'un filtre optique destiné à éviter une pollution de l'image par la composante infrarouge.

Les documents :

- D. Kiku et al. « Simultaneously Capturing of RGB and Additional Band Images using Hybrid Color Filter Array », Proc. of SPIE-IS&T Electronic Imaging, SPIE Vol. 9023 (2014); et
- US 8,619,143

décrivent des capteurs matriciels comportant des pixels de quatre types différents : des pixels sensibles à la lumière bleue, à la lumière verte et à la lumière rouge comme dans les capteurs « RVB » conventionnels, mais aussi des pixels « gris », sensibles uniquement au rayonnement PIR. De manière conventionnelle, ces différents types de pixels sont obtenus par le dépôt de filtres absorbants, formant une matrice de filtres de couleur, sur des capteurs élémentaires en silicium qui sont, par eux-mêmes, « panchromatiques », c'est à dire sensibles à toute la bande visible et proche infra-rouge. En général, les pigments utilisés pour réaliser ces filtres sont transparents dans le proche infrarouge ; les images acquises par les pixels « rouges », « verts » et « bleues » sont donc affectées par la composante infrarouge de la lumière incidente (car le filtre optique utilisé dans les caméras conventionnelles est, évidemment, absent) et un traitement numérique est nécessaire pour récupérer des couleurs proches de la réalité.

Les documents :

- Z. Sadeghipoor et al. « Designing Color Filter Arrays for the Joint Capture of Visible and Near-Infrared images », 16th IEEE Conférence on Image Processing (2009);
- Z. Sadeghipoor et al. « Correlation-Based Joint Acquisition and Demosaicing of Visible and Near-Infrared Images », 18th IEEE Conférence on Image Processing (2011)

décrivent des capteurs présentant une matrice de filtre de couleurs plus complexe, destinée à optimiser la reconstruction des images visible et infrarouge.

Inversement, le document

- Z. Sadeghipoor et al. « A Novel Compressive Sensing Approach to Simultaneously Acquire Color and Near Infrared Images on a Single Sensor » Proc. IEEE International Conférence on Acoustics, Speech and Signal Processing (ICASSP), Vancouver, Canada (2013)

décrit un capteur dont la matrice de filtres de couleur est proche, mais légèrement différente, de la matrice dite « de Bayer », qui est la plus couramment utilisée dans les cameras couleurs. Une matrice de Bayer conventionnelle ne permettrait pas de séparer les composantes visibles et infrarouge.

Ces approches utilisent des capteurs dans lesquels tous les pixels sont équipés d'un filtre spectral. Or, afin de réaliser des caméras à haute sensibilité, il est avantageux d'utiliser des capteurs comprenant aussi des pixels panchromatiques, sans filtres. Dans certains cas on utilise même des capteurs dit « épars » (« sparse » en anglais) comportant un pourcentage élevé de pixels panchromatiques afin de capter la plus grande partie du rayonnement incident. Ces capteurs exploitent le fait que la chrominance d'une image peut être sous-échantillonnée par rapport à sa luminance sans qu'un observateur ne perçoive une dégradation significative de sa qualité.

Le document :

- D. Hertel et al. « A low-cost VIS-NIR true color night vision video system based on a wide dynamic range CMOS imager », IEEE Intelligent Vehicles Symposium, 2009, pages 273 - 278;

décrit l'utilisation d'un capteur comprenant des pixels colorés et des pixels panchromatiques pour l'acquisition simultanée d'images visibles et dans le proche infrarouge. La méthode de construction des images PIR n'est pas explicitée et aucun exemple de telles images n'est montré ; seules sont montrées des images monochromatiques « pleine bande » exploitables en conditions de faible éclairement. Par ailleurs, cet article ne concerne que le cas d'un capteur « RGBM », qui ne contient que 25% de pixels panchromatiques, ce qui limite fortement le gain en sensibilité pouvant être atteint.

L'invention vise à surmonter les inconvénients précités de l'art antérieur. Plus précisément elle vise à procurer un système d'acquisition simultanée d'images visibles et PIR présentant une grande sensibilité et permettant d'obtenir des images de qualité élevée. De préférence, l'invention permet l'utilisation de capteurs matriciels et de systèmes optiques du commerce (« composants pris sur étagère », ou COTS de l'anglais « commercial off-the-shelf »).

Conformément à l'invention, une sensibilité élevée est obtenue grâce à l'utilisation de capteurs comprenant à la fois des pixels colorés (comprenant ou pas des pixels « gris » sensibles au PIR) et des pixels panchromatiques en nombre assez élevé (de préférence supérieur en nombre à un quart des pixels), et de préférence des capteurs épars ; la qualité d'image élevée est obtenue par la mise en œuvre d'un traitement numérique innovant. Plus précisément, ce traitement comporte la reconstruction d'une image panchromatique et de deux images visibles « intermédiaire » en couleurs. Ces deux images visibles intermédiaires sont obtenues au moyen de deux traitements différents : l'un, qu'on peut qualifier de « intra-canal », exploite seulement les signaux issus des pixels colorés tandis que l'autre, qu'on peut qualifier de « inter-canaux », exploite également l'image panchromatique. L'image PIR est obtenue à partir de l'image en couleur « inter-canaux » et de l'image panchromatique, tandis que l'image en couleur est obtenue en combinant l'image intermédiaire « intra-canal » avec l'image panchromatique.

Un objet de l'invention est donc un système d'acquisition d'images comprenant : un capteur matriciel comprenant un agencement bidimensionnel de pixels, chaque pixel étant adapté pour générer un signal électrique représentatif de l'intensité lumineuse en un point d'une image optique d'une scène ; et un circuit de traitement de signaux configuré pour traiter les signaux électriques générés par lesdits pixels de manière à générer des images numériques de ladite scène ; dans lequel ledit capteur matriciel comprend un arrangement bidimensionnel : de pixels, dits colorés, d'au moins un premier type, sensibles à la lumière visible dans une première plage spectrale; un deuxième type, sensibles à la lumière visible dans une deuxième plage spectrale différente de la première ; et un troisième type, sensibles à la lumière visible dans une troisième plage spectrale différente de la première et de la deuxième, une combinaison des plages spectrales des différents types de pixels colorés reconstituant l'ensemble du spectre visible ; et de pixels, dits panchromatiques, sensibles à l'ensemble du spectre visible, au moins les pixels panchromatiques étant également sensibles au proche infrarouge ; caractérisé en ce que ledit circuit de traitement de signaux est configuré pour : reconstruire un premier ensemble d'images monochromatiques à partir des signaux électriques générés par les pixels colorés ; reconstruire une image panchromatique à partir des signaux électriques générés par les pixels panchromatiques ; reconstruire un deuxième ensemble d'images monochromatiques à partir des signaux électriques générés par les pixels colorés, et de ladite image panchromatique ; reconstruire une image en couleurs par application d'une première matrice de colorimétrie aux images monochromatiques du premier ensemble et à ladite image panchromatique ; reconstruire au moins une image dans le proche infrarouge par application d'une deuxième matrice de colorimétrie au moins aux images monochromatiques du deuxième ensemble et à ladite image panchromatique ; et fournir en sortie ladite image en couleurs et ladite ou au moins une dite image dans le proche infrarouge. Les images du premier ensemble sont obtenues uniquement à partir des signaux électriques générés par les pixels colorés, sans contribution des signaux électriques générés par les pixels panchromatiques. En outre, la première matrice de colorimétrie sera telle que l'image en couleur produite en sortie soit sensiblement exempte de contributions provenant d'une composante infrarouge de l'image optique, tandis que les images du deuxième ensemble comprendront de telles contributions.

Selon des modes de réalisation particuliers de l'invention :

- Lesdits pixels colorés peuvent comprendre uniquement les pixels desdits premier, deuxième et troisième type, qui sont également sensibles au proche infrarouge. Plus particulièrement, les pixels d'un parmi le premier, le deuxième et le troisième type peuvent être sensibles à la lumière verte, ceux d'un autre parmi le premier, le deuxième et le troisième type être sensibles à la lumière bleue et ceux du type restant parmi le premier, le deuxième et le troisième type être sensibles à la lumière rouge.

- Ledit capteur matriciel peut être de type épars, plus d'un quart et de préférence au moins la moitié de ses pixels étant panchromatiques.

- Ledit circuit de traitement de signaux peut être configuré pour reconstruire les images monochromatiques dudit premier ensemble par application d'une méthode comprenant les étapes suivantes : déterminer l'intensité lumineuse associée à chaque pixel dudit premier type et reconstruire une première image monochromatique dudit premier ensemble par interpolation desdites intensités lumineuses ; déterminer l'intensité lumineuse associée à chaque pixel coloré des autres types, et en soustraire une valeur représentative de l'intensité associée à un pixel correspondant de ladite première image monochromatique ; reconstruire de nouvelles images monochromatiques par interpolation des valeurs d'intensité lumineuse des pixels colorés respectifs desdits autres types, auxquelles ont été soustraites lesdites valeurs représentatives de l'intensité associée à un pixel correspondant de ladite première image monochromatique, puis combiner ces nouvelles images reconstruites avec ladite première image monochromatique pour obtenir des images monochromatiques finales respectives dudit premier ensemble.

- Ledit circuit de traitement de signaux peut être configuré pour reconstruire ladite image panchromatique par interpolation des signaux électriques générés par les pixels panchromatiques.

- Ledit circuit de traitement de signaux peut être configuré pour reconstruire les images monochromatiques dudit deuxième ensemble en calculant le niveau de luminance de chaque pixel de chaque dite image par application d'une fonction linéaire, définie localement, à la luminance du pixel correspondant dans l'image panchromatique.

- En variante, ledit circuit de traitement de signaux peut être configuré pour reconstruire les images monochromatiques dudit deuxième ensemble en calculant le niveau de luminance de chaque pixel de chaque dite image au moyen d'une fonction non-linéaire des niveaux de luminance d'une pluralité de pixels de l'image panchromatique dans un voisinage du pixel de laite image panchromatique correspondant audit pixel de ladite image du deuxième ensemble et/ou de l'intensité lumineuse d'une pluralité de pixels colorés .

- Ledit capteur matriciel peut être constitué d'une répétition périodique de blocs contenant des répartitions pseudo-aléatoires de pixels des différents types et dans lequel ledit circuit de traitement de signaux est configuré pour : extraire des motifs réguliers de pixels de mêmes types dudit capteur matriciel ; et reconstruire lesdits premier et deuxième ensembles d'images monochromatiques en traitant de manière parallèle lesdits motifs réguliers de pixels de mêmes types.

- Ledit circuit de traitement de signaux peut être également configuré pour reconstruire une image monochromatique à bas niveau de luminosité par application d'une troisième matrice de colorimétrie au moins aux images monochromatiques du deuxième ensemble et à ladite image panchromatique.

- Ledit capteur matriciel peut comprendre également un arrangement bidimensionnel de pixels uniquement sensibles au proche infrarouge, et dans lequel ledit circuit de traitement de signaux est configuré pour reconstruire ladite image dans le proche infrarouge également à partir des signaux électriques générés par ces pixels.

- Le système peut comprendre également un actionneur pour produire un déplacement périodique relatif entre le capteur matriciel et l'image optique le capteur matriciel étant adapté pour reconstruire lesdits premier et deuxième ensembles d'images monochromatique et ladite image panchromatique à partir de signaux électriques générés par les pixels du capteur matriciel en correspondance d'une pluralité de positions relatives distinctes du capteur matriciel et de l'image optique.

- Ledit circuit de traitement de signaux peut être réalisé à partir d'un circuit logique programmable.

Un autre objet de l'invention est une caméra bi-spectrale visible - proche infrarouge comprenant un tel système d'acquisition d'images et un système optique adapté pour former une image optique d'une scène sur un capteur matriciel du système d'acquisition d'images, sans filtrage du proche infrarouge.

Encore un autre objet de l'invention est un procédé d'acquisition simultanée d'images en couleurs et dans le proche infrarouge par utilisation d'une telle caméra bi-spectrale.

D'autres caractéristiques, détails et avantages de l'invention ressortiront à la lecture de la description faite en référence aux dessins annexés donnés à titre d'exemple et qui représentent, respectivement :

- La figure 1A, un schéma fonctionnel d'une caméra selon un mode de réalisation de l'invention ;
- La figure 1B, des graphiques illustrant la réponse spectrale des pixels du capteur matriciel de la caméra de la figure 1A ;
- La figure 2, un schéma fonctionnel du traitement mis en œuvre par le processeur de la caméra de la figure 1A selon un mode de réalisation de l'invention ;
- Les figures 3A à 6C, des schémas illustrant différentes étapes du traitement de la figure 2 ;
- Les figures 7A et 7B, deux schémas illustrant deux variantes d'un traitement mis en œuvre dans un mode de réalisation particulier de l'invention ;
- La figure 8, un capteur matriciel d'un système d'acquisition d'images selon une autre variante de l'invention ;
- Les figures 9A et 9B, des images illustrant des résultats techniques de l'invention.

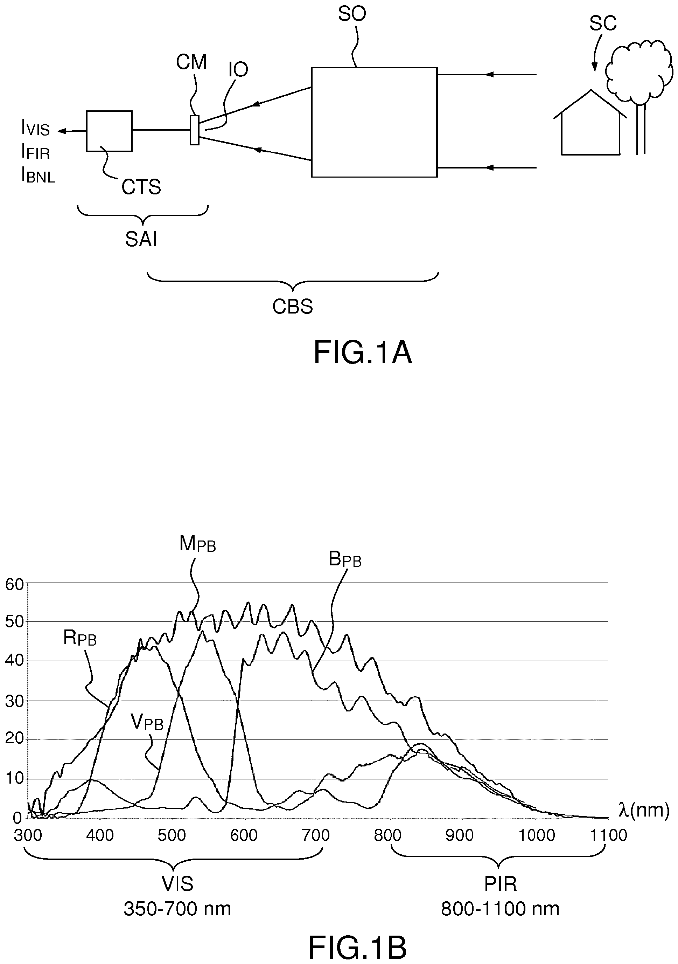

La figure 1A montre le schéma fonctionnel, très simplifié, d'une caméra bi-spectrale visible - proche infrarouge CBS selon un mode de réalisation de l'invention. La caméra CBS comprend un système optique SO, généralement basé sur des lentilles, qui forme une image optique IO d'une scène observée SC. L'image IO est formée à la surface d'un capteur matriciel CM, comprenant un agencement bidimensionnel de pixels ; chaque pixel produit un signal électrique représentatif de l'intensité lumineuse du point (en fait, d'une petite région) correspondant de l'image optique, pondérée par sa courbe de sensibilité spectrale. Ces signaux électriques, généralement après avoir été convertis au format numérique, sont traités par un circuit de traitement CTS qui fournit à sa sortie des images numériques : une première image en couleurs (constituée de trois images monochromatiques de couleurs différentes) $I_{VIS}$ et une seconde image, monochromatique, dans le proche infrarouge. Optionnellement, le circuit de traitement CTS peut fournir en sortie également une image monochromatique visible $I_{BNL}$, utile en particulier lorsque la scène observée présente un bas niveau de luminosité. Le capteur matriciel CM et le circuit de traitement CTS constituent ce qu'on appellera par la suite un système d'acquisition d'images. Le circuit CTS peut être un microprocesseur, de préférence spécialisé pour le traitement numérique des signaux (DSP, de l'anglais « Digital Signal Processor ») programmé de manière opportune, ou bien un circuit numérique dédié, réalisé par exemple à partir d'un circuit logique programmable tel qu'un FPGA ; il peut cependant s'agir aussi d'un circuit intégré spécifique (ASIC, de l'anglais « Application Specific Integrated Circuit).

Le capteur matriciel peut être de type CCD ou CMOS ; dans ce dernier cas, il peut intégrer un convertisseur analogique - numérique de manière à fournir directement des signaux numériques à sa sortie. En tout cas, il comprend au moins quatre types différents de pixels : trois premiers types sensibles à des bandes spectrales correspondant à des couleurs qui, mélangées, restituent le blanc de la bande spectrale visible (typiquement le rouge, le vert et le bleu) et un quatrième type « panchromatique ». Dans un mode de réalisation préféré, tous ces types de pixels présentent également une sensibilité non nulle dans le proche infrarouge - ce qui est le cas des capteurs en silicium. Cette sensibilité dans le proche infrarouge est généralement considérée comme une nuisance, et supprimée à l'aide d'un filtre optique, mais est exploitée par l'invention. Avantageusement, les pixels présentent tous une même structure, et ne diffèrent que par un revêtement filtrant à leur surface (absent dans le cas des pixels panchromatiques), généralement à base de polymères. La figure 1B montre les courbes de sensibilité des pixels rouges ($R_{PB}$), verts ($V_{PB}$), bleus ($B_{PB}$) et panchromatiques ($M_{PB}$). On remarque que la sensibilité dans le proche infrarouge est sensiblement la même pour les quatre types de pixels. L'index « PB » signifie « pleine bande », pour indiquer que la composante infrarouge du rayonnement incident n'a pas été filtrée.

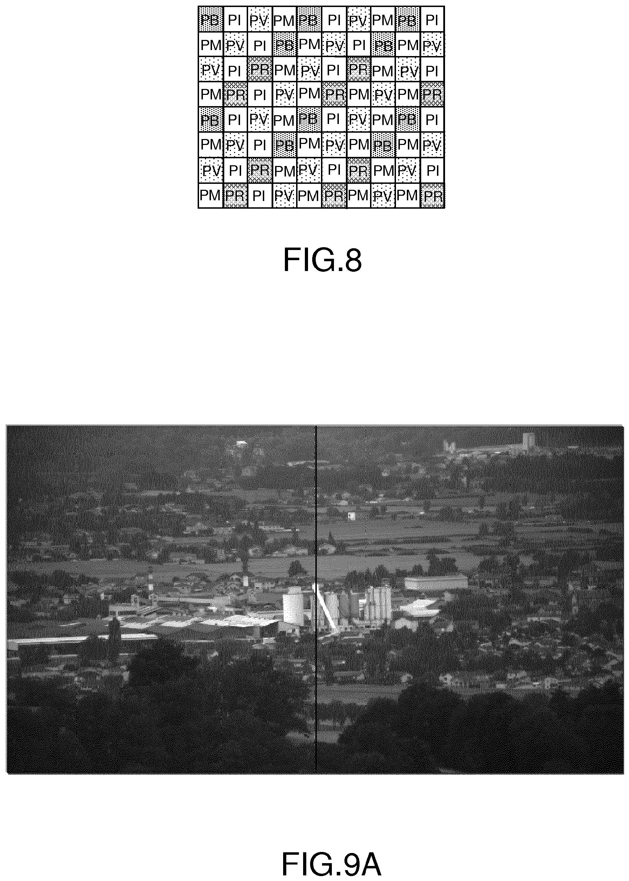

Comme cela sera expliqué en détail plus loin, en référence à la figure 8, le capteur peut comprendre aussi des pixels d'un cinquième type, sensibles uniquement au proche infrarouge.

La figure identifie les plages spectrales visible (350 - 700 nm) VIS et proche infrarouge (800 - 1100) PIR. La bande intermédiaire (700 - 800 nm) peut être filtrée, mais cela n'est pas avantageux dans le cas de l'invention ; plus utilement, elle peut être considérée comme du proche infrarouge.

Avantageusement, le capteur matriciel CM peut être « épars », ce qui signifie que les pixels panchromatiques sont au moins aussi nombreux, et de préférence plus nombreux, que ceux de chacune des trois couleurs. Avantageusement, au moins la moitié des pixels sont panchromatiques. Cela permet d'améliorer la sensibilité du capteur car les pixels panchromatiques, ne comportant aucun filtre, reçoivent plus de lumière que les pixels colorés.

L'agencement des pixels peut être pseudo-aléatoire, mais est de préférence régulier (c'est-à-dire périodique selon les deux dimensions spatiales) afin de faciliter les opérations de traitement d'images. Il peut notamment s'agir d'une périodicité sur un motif aléatoire, c'est-à-dire d'une répétition périodique de blocs à l'intérieur desquels les pixels sont distribués de manière pseudo-aléatoire.

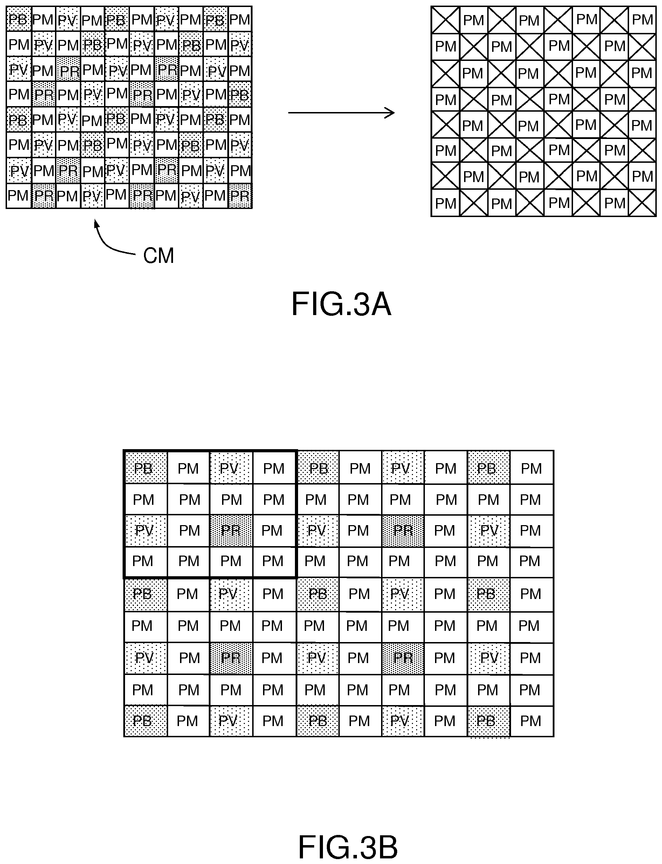

A titre d'exemple, la partie gauche de la figure 3A montre le schéma d'un capteur matriciel dans lequel un pixel sur deux est du type panchromatique (PM), un sur quatre est vert (PV), un sur huit est rouge (PR) et un sur huit est bleu (PB). Le fait que les pixels verts soient plus nombreux que les rouges ou les bleus dans cet exemple reflète le fait que l'œil humain présente un pic de sensibilité pour cette couleur, mais cette proportion entre pixels verts, bleus et rouge n'est pas obligatoire dans l'invention (elle gère toute autre proportion existante entre ces différents types de pixels).

Il est également possible d'utiliser un capteur obtenu par la répétition régulière d'un bloc de dimensions MxN contenant une distribution de pixels colorés et panchromatiques pseudo-aléatoire (mais avec une répartition contrôlée entre ces différents types de pixels).

Par exemple, la figure 3B montre un schéma de capteur, dit « 1/16 » (« 1/N » voulant dire qu'un pixel sur N est bleu ou rouge), pour lequel on distingue des schémas de 4x4 pixels répétés, dans lesquels sont distribués aléatoirement 12 pixels de type panchromatique, 1 pixel de type rouge, 1 pixel de type bleu et 2 pixels de type vert. On comprend bien que plusieurs configurations de motifs de distribution aléatoires sont possibles que cela soit dans la figure 3A (éparse de type « 1/8 ») ou 3B (éparse de type « 1/16 »).. Certains motifs peuvent être choisis de manière préférentielle pour leurs performances obtenues sur les images de sortie avec les traitements qui seront décrits plus loin.

Il est également possible d'utiliser plus de trois types de pixels colorés, présentant des bandes de sensibilité différentes, afin d'obtenir une pluralité d'images visibles (et, le cas échéant, dans le proche infrarouge) monochromatiques correspondant à ces bandes. On peut ainsi obtenir des images hyperspectrales.

Par ailleurs, il n'est pas essentiel que les pixels colorés (ou la totalité d'entre eux) soient sensibles au proche infrarouge : il peut être suffisant que les pixels panchromatiques le soient.

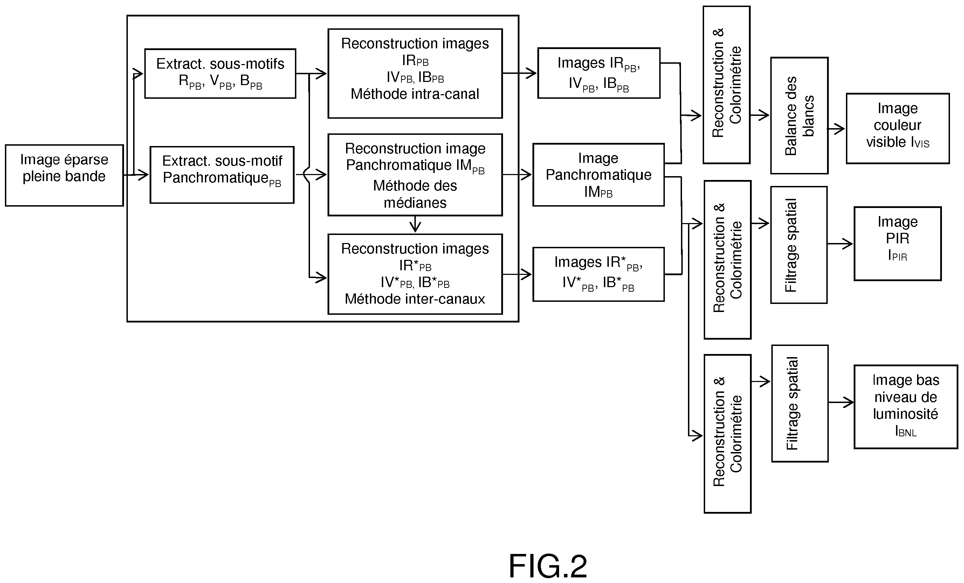

La figure 2 illustre schématiquement le traitement mis en œuvre par le circuit de traitement CTS. Les différentes étapes de ce traitement seront détaillées plus loin en référence aux figures 3A à 6C.

Le circuit CTS reçoit en entrée un ensemble de signaux numériques représentant les valeurs d'intensité lumineuse détectés par les différents pixels du capteur matriciel CM. Sur la figure, cet ensemble de signaux est désigné par l'expression « image éparse pleine bande ». La première opération de traitement consiste à extraire de cet ensemble les signaux correspondants aux pixels des différents types. En considérant le cas d'un agencement régulier de blocs de pixels MxN (M>1 et/ou N>1), on parle de l'extraction des « motifs » $R_{PB}$ (rouge pleine bande), $V_{PB}$ (vert pleine bande), $B_{PB}$ (bleu pleine bande) et $M_{PB}$ (panchromatique pleine bande). Ces motifs (« patterns » en anglais) correspondent à des images sous-échantillonnées, ou « à trous » ; il est donc nécessaire de procéder à une reconstruction d'images complètes, échantillonnées au pas du capteur matriciel.

La reconstruction d'une image panchromatique pleine bande $IM_{PB}$ constitue l'opération la plus simple, en particulier lorsque les pixels panchromatiques sont les plus nombreux. Tel est le cas de la figure 3, où un pixel sur deux est panchromatique. L'intensité lumineuse correspondante aux pixels « manquants » (c'est-à-dire bleus, verts ou rouges et donc non directement utilisables pour reconstituer l'image panchromatique) peut être calculée, par exemple par une simple interpolation bilinéaire. La méthode qui s'est avérée la plus efficace est celle dite « des médianes » : chaque pixel « manquant » se voit attribuer une valeur d'intensité lumineuse qui est la médiane des valeurs d'intensité lumineuse mesurées par les pixels panchromatiques constituant ses plus proches voisins.

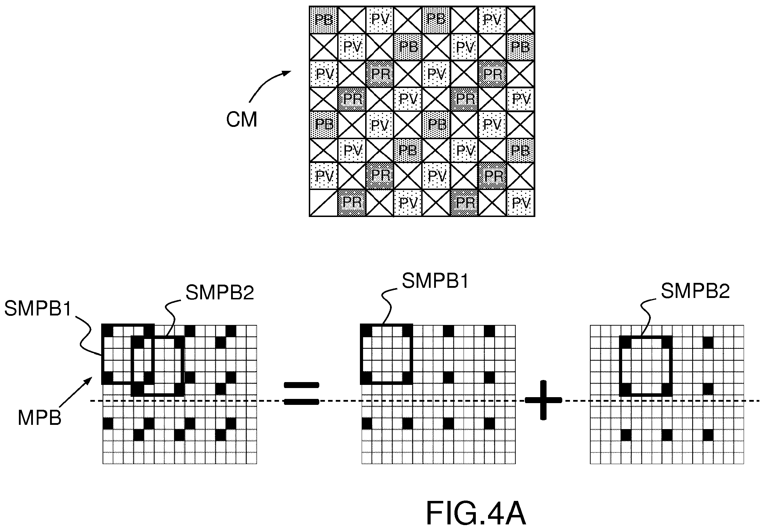

La reconstruction des images colorées (rouge, verte, bleue) pleine bande est effectuée deux fois, au moyen de deux méthodes différentes. Une première méthode est dite « intra-canal », car elle n'utilise que les pixels colorés pour reconstruire les images colorées ; une deuxième méthode est dite « inter-canaux », car elle utilise aussi l'information issue des pixels panchromatiques. Des exemples de telles méthodes seront décrits plus loin, en référence aux figures 4A - 4D (intra-canal) et 5 (inter-canaux). Conventionnellement, seules les méthodes intra-canal sont utilisées.

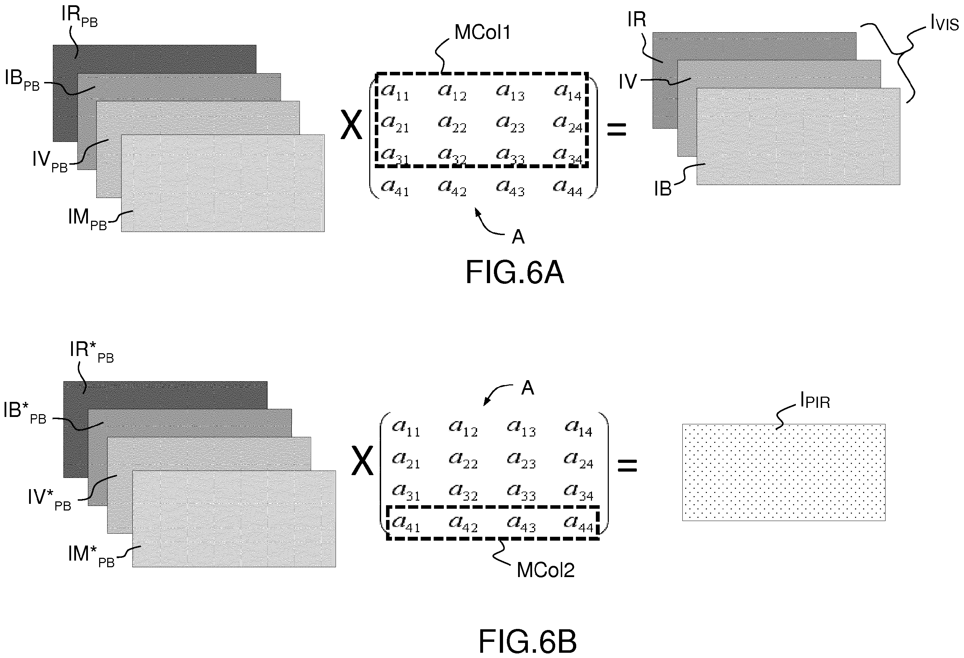

Les images pleine bande, qu'elles soient obtenues par une méthode intra-canal ou inter-canaux ne sont pas directement exploitables, car elles sont « polluées » par la composante PIR (proche infrarouge) non filtrée par le système optique. Cette composante PIR peut être éliminée en combinant les images pleine bande $IR_{PB}$, $IV_{PB}$, $IB_{PB}$ obtenues par la méthode intra-canal avec l'image panchromatique pleine bande au moyen d'une première matrice de colorimétrie (référence MCol1 sur la figure 6A). On obtient ainsi une image visible en couleurs $I_{VIS}$, formée de trois sous-images monochromatiques IR, IV, IB rouge, verte et bleue, respectivement.

Les images pleine bande $IR^*_{PB}$, $IV^*_{PB}$, $IB^*_{PB}$ obtenues par la méthode inter-canaux sont, elles aussi, combinées avec l'image panchromatique pleine bande au moyen d'une deuxième matrice de colorimétrie (référence MCol2 sur la figure 6B). Les éléments de cette matrice, servant de coefficients de la combinaison, sont choisis pour permettre l'obtention d'une image dans le proche infrarouge $I_{PIR}$ (ou, plus précisément, une image monochromatique, généralement en noir et blanc, représentative de la luminance de l'image IO dans la plage spectrale du proche infrarouge).

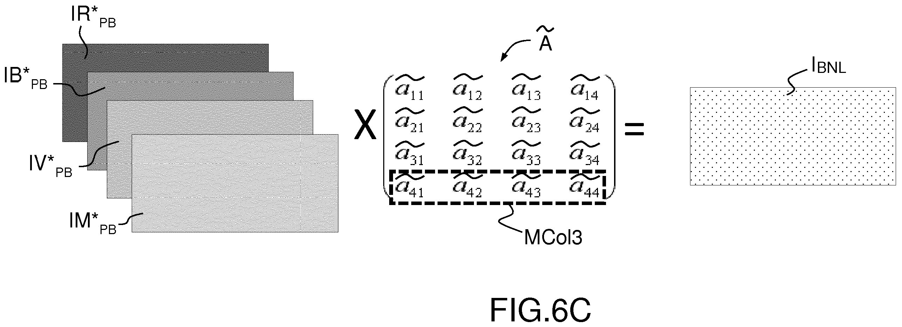

Optionnellement, la combinaison des images pleine bande $IR^*_{PB}$, $IV^*_{PB}$, $IB^*_{PB}$ obtenues par la méthode inter-canaux avec l'image panchromatique pleine bande au moyen d'une troisième matrice de colorimétrie (référence MCol3 sur la figure 6C) permet d'obtenir une image monochromatique $I_{BNL}$ représentative de la luminance de l'image IO dans toute la plage spectrale visible, mais sans pollution par les composantes infrarouges. Comme elle exploite les signaux issus des capteurs panchromatiques, plus nombreux et dépourvus de filtre, cette image peut être plus lumineuse que l'image en couleurs $I_{VIS}$ et convenir donc particulièrement bien aux conditions de faible éclairage. Il est important de noter que l'image $I_{BNL}$ ne contient pas de contribution dans le proche infrarouge, qui est pour ainsi dire filtrée numériquement. Par contre, l'article précité de D. Hertel et al. décrit l'obtention d'une image « à bas niveau de lumière » qui combine images dans le visible et dans le proche infrarouge. Une telle image est visuellement différente d'une image purement dans le visible, comme $I_{BNL}$.

Dans certains cas, on pourrait être intéressés uniquement par l'image dans le proche infrarouge $I_{PIR}$ et éventuellement par l'image visible monochromatique à basse luminosité $I_{BNL}$. Dans ces cas, il ne serait pas nécessaire de mettre en œuvre la méthode de reconstruction intra-canal.

Une méthode avantageuse de reconstruction d'image de type « intra-canal »sera maintenant décrite en référence aux figures 4A - 4D. Cette description est donnée uniquement à titre d'exemple car de nombreuses autres méthodes connues dans la littérature (approches de diffusion, par ondelettes, par constance de teinte...) peuvent convenir à la mise en œuvre de l'invention.

Dans le capteur matriciel de la figure 3A, les pixels bleus sont regroupés en sous-motifs (ou sous-patterns) réguliers. Le motif MPB formé par ces pixels peut être décomposé en deux sous-motifs SMPB1, SMPB2 identiques entre eux mais décalés spatialement ; chacun de ces sous-motifs présente quatre pixels bleus aux coins d'un carré de 5 x 5 pixels ; cela est illustré sur la figure 4A. Ce procédé de décomposition en sous-motifs réguliers est applicable aux pixels de différents types quelque soit l'agencement aléatoire de ceux-ci défini dans un bloc de MxN pixels. En particulier lorsque le circuit de traitement CTS est réalisé au moyen d'un circuit numérique dédié, il est avantageux de décomposer le motif MPV en sous-motifs qui peuvent être traités de manière parallèle.

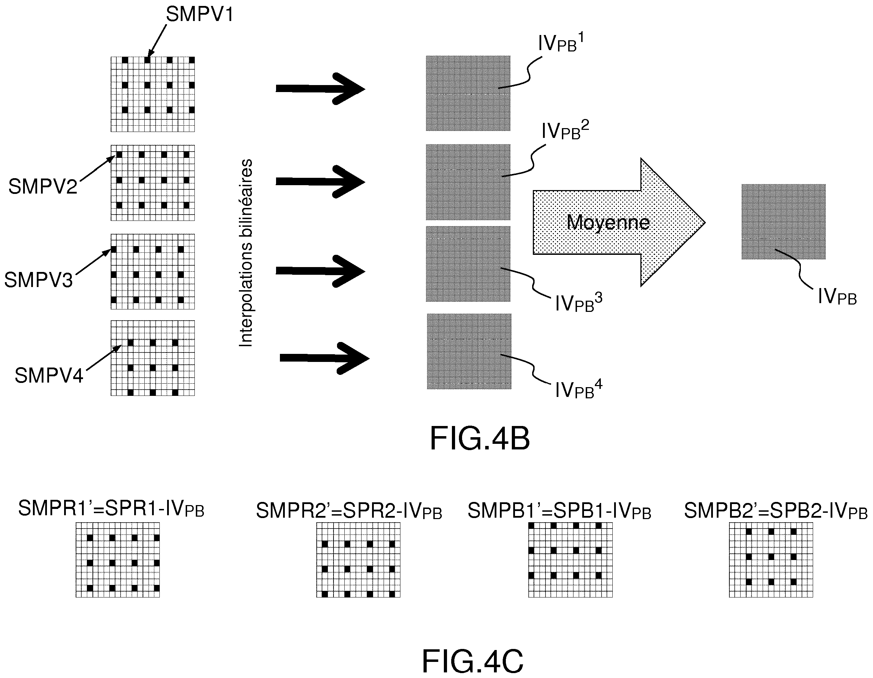

La figure 4B illustre un cas où le motif de pixels verts est décomposé en quatre sous-motifs SMPV1, SMPV2, SMPV3 et SMPV4. Des images monochromatiques vertes complètes, $IV_{PB}^1$, $IV_{PB}^2$, $IV_{PB}^3$, $IV_{PB}^4$, sont obtenues par interpolation bilinéaire de ces sous-motifs. Puis une image monochromatique verte « en pleine bande » $IV^{PB}$ est obtenue en les moyennant.

La reconstruction des images rouges et bleues en pleine bande est un peu plus complexe. Elle est basée sur une méthode proche de la « constance de teinte » décrite dans US 4,642,678.

Premièrement, on soustrait l'image verte pleine bande $IV^{PB}$ des motifs de pixels rouge et bleu. Plus précisément cela signifie que l'on soustrait du signal issu de chaque pixel rouge ou bleu une valeur représentative de l'intensité du pixel correspondant de l'image verte en pleine bande $IV^{PB}$. Le motif de pixels rouges est décomposé en deux sous-motifs SMPR1, SMPR2; après soustraction on obtient les sous-motifs modifiés SMPR1', SMPR2' ; de même le motif de pixels bleus est décomposé en deux sous-motifs SMPB1, SMPB2 ; après soustraction on obtient les sous-motifs modifiés SMPB1', SMPB2'. Cela est illustré sur la figure 4C.

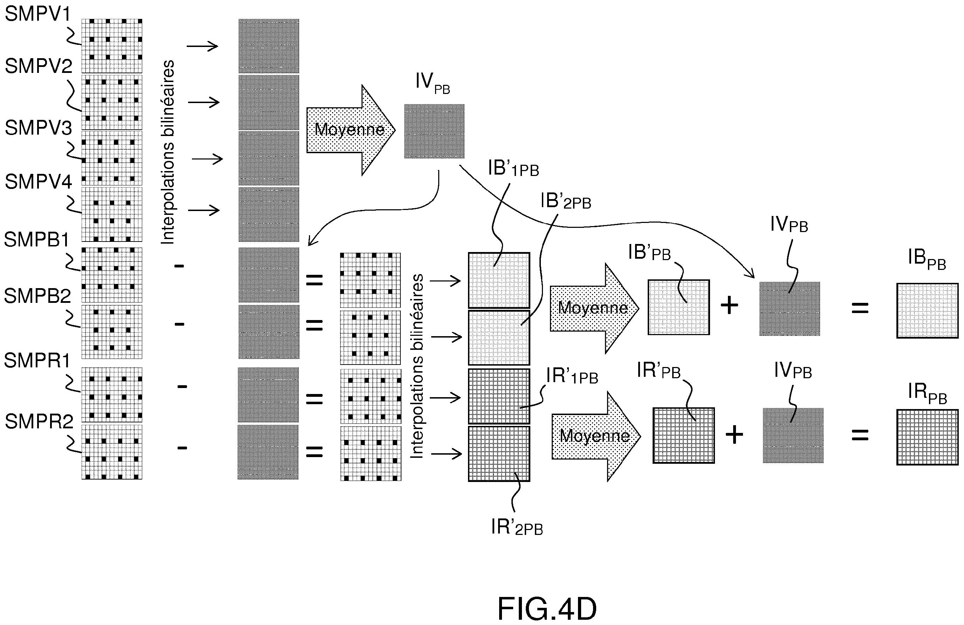

Ensuite, comme illustré sur la figure 4D, des images $IR1'_{PB}$, $IR2'_{PB}$ sont obtenues par interpolation bilinéaire des sous-motifs rouges, et moyennées pour fournir une image rouge modifiée $IR_{PB}'$. De même, des images $IB1'_{PB}$, $IB2'_{PB}$ sont obtenues par interpolation bilinéaire des sous-motifs rouges, et moyennées pour fournir une image bleue modifiée $IB_{PB}'$.

L'image rouge pleine bande $IR_{PB}$ et l'image bleue pleine bande $IB_{PB}$ sont obtenues en ajoutant l'image verte pleine bande $IV_{PB}$ aux images rouge et bleue modifiées $IR_{PB}'$, $IB_{PB}'$.

L'intérêt de procéder de cette façon, en soustrayant l'image verte reconstruite des motifs de pixels rouges et bleus pour la rajouter à la fin du traitement, est que les motifs modifiés présentent une dynamique d'intensité faible, ce qui permet de réduire les erreurs d'interpolation. Le problème est moins aigu pour le vert, qui est échantillonné plus finement.

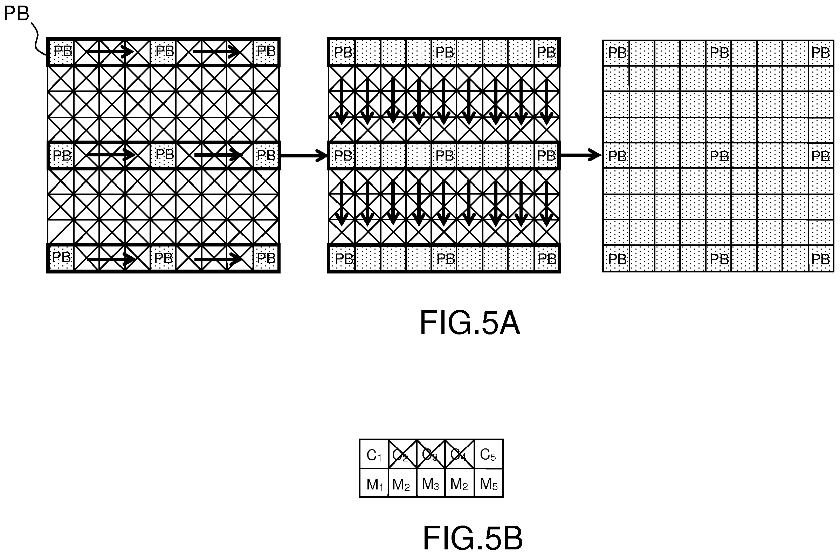

La reconstruction inter-canaux est réalisée de manière différente. Elle exploite explicitement les pixels panchromatiques, contrairement à la reconstruction intra-canaux qui n'exploite que les pixels rouges, verts, bleus. A titre d'exemple, elle peut être réalisée au moyen d'un algorithme que l'on peut qualifier de « loi monochrome », qui est illustré à l'aide des figures 5A et 5B. L'idée à la base de cet algorithme est que les composantes colorées - verte, rouge et bleue - présentent généralement des variations spatiales qui « suivent » approximativement celles de la composante panchromatique. On peut donc se servir de la composante panchromatique, reconstituée par interpolation bilinéaire en bénéficiant de son échantillonnage spatial plus dense, pour calculer le niveau de luminance des pixels manquants des composantes colorées. Plus particulièrement, le niveau de luminance de chaque pixel coloré peut être déterminé par application d'une fonction linéaire ou affine à la luminance du pixel correspondant de l'image panchromatique. La fonction linéaire ou affine en question est déterminée localement et dépend du niveau de luminance des pixels colorés proches déjà connus (car mesurés directement ou déjà calculés).

La figure 5A se rapporte au cas d'un capteur épars dans lequel seulement une ligne sur quatre contient des pixels bleus ; au sein de ces lignes, un pixel sur quatre est bleu. On dispose également d'une image panchromatique « pleine », définie pour tous les pixels du capteur, obtenue de la manière décrite plus haut en référence à la figure 3. La figure 5B montre un segment du capteur matriciel comprenant deux pixels bleus séparés par trois pixels pour lesquels la composante bleue n'est pas définie ; superposée à cette portion de ligne, on dispose d'une portion d'image panchromatique, définie sur tous les pixels. On désigne par $C_1$ et $C_5$ les luminances connues des deux pixels bleus (plus généralement, colorés) aux extrémités du segment de ligne, par $C_2$, $C_3$ et $C_4$ les luminances - à calculer - de la composante bleue en correspondance de trois pixels intermédiaires, et par $M_1$ - $M_5$ les luminances, connues, de l'image panchromatique en correspondance de ces mêmes pixels.

La première étape de la méthode consiste à reconstruire des lignes de la composante bleue de l'image à l'aide de l'image panchromatique ; seules les lignes contenant les pixels bleus sont reconstruites de cette façon, soit une ligne sur quatre. A l'issue de cette étape, on dispose de lignes bleues complètes, séparées par des lignes dans lesquelles la composante bleue n'est pas définie. Si on s'intéresse aux colonnes, on remarque que dans chaque colonne un pixel sur quatre est bleu. On peut donc reconstituer des colonnes bleues par interpolation aidée par la connaissance de l'image panchromatique, comme on l'a fait pour les lignes. On procède de la même façon pour les composantes verte et rouge.

L'application de la loi monochrome pour reconstruire une composante colorée de l'image se déroule de la manière suivante.

On s'intéresse aux pixels $M_1$ à $M_5$ de l'image panchromatique reconstituée qui se situent entre deux pixels $C_1$ et $C_5$ du motif de la couleur considérée, y compris les pixels extrêmes $M_1$, $M_5$ qui sont co-localisés avec ces deux pixels colorés. Puis on détermine si la portion correspondante de l'image panchromatique peut être considérée uniforme. Pour ce faire, on compare la variation totale de luminance panchromatique entre $M_1$ et $M_5$ à un seuil Th. Si $|M_5 - M_1| <$ Th, alors la zone est considérée comme uniforme, autrement elle est considérée non-uniforme.

Si la zone de l'image panchromatique est considérée uniforme, on vérifie si la luminance panchromatique totale $M_1+M_2+M_3+M_4+M_5$ est inférieure à un seuil, fonction notamment du bruit thermique, auquel cas l'image panchromatique ne contient pas d'informations exploitables et la reconstruction de la composante colorée (plus précisément : le calcul de la luminance des pixels colorés $C_2$, $C_3$ et $C_4$) se fait par interpolation linéaire entre $C_1$ et $C_5$. Autrement, on procède à une reconstruction de proche en proche :

$$C_2 = C_1 \cdot \frac{M_2}{M_1} \; ;$$

$$C_3 = C_2 \cdot \frac{M_3}{M_2} \; ;$$

$$C_4 = C_3 \cdot \frac{M_3}{M_2}$$

En d'autres termes, la luminance de chaque pixel coloré à reconstruire est déterminée à partir de celle du pixel coloré immédiatement précédent, dans l'ordre de reconstruction, en y appliquant le taux de variation locale mesuré sur l'image panchromatique.

Si la luminance doit être une valeur entière, le résultat calculé est arrondi.

Si la zone de l'image panchromatique n'est pas considérée uniforme ($|M_5 - M_1| \geq$ Th), alors on peut reconstruire directement les pixels colorés $C_2$ - $C_4$ par application d'une « loi monochrome », c'est-à-dire de la fonction affine exprimant $C_i$ en fonction de $M_i$ (i=1 - 5) et telle que les valeurs calculées de $C_1$ et de $C_5$ coïncident avec les valeurs mesurées :

$$C_i = m \cdot M_i + p$$

avec

$$m = \left| \frac{C_5 - C_1}{M_5 - M_1} \right|$$

et

$$p = C_1 - m \cdot M_1$$

Là encore, si la luminance doit être une valeur entière, le résultat calculé est arrondi.

La reconstruction par application directe de la loi monochrome peut conduire à une dynamique trop grande de la composante colorée reconstruite, ou bien à sa saturation. Dans ce cas, il peut être opportun de revenir à une reconstruction de proche en proche. Par exemple, une condition de dynamique trop grande peut être constatée lorsque

$$\frac{max(M_i)}{min(M_i)} + Th1 < \frac{max(C_i)}{min(C_i)}$$

où Th1 est un seuil, généralement différent de Th.

Une saturation peut être constatée si $min(C_i)<0$ ou si $Max(C_i)$ est supérieur à une valeur maximale admissible (65535 si on considère le cas d'une luminance exprimée par un nombre entier codé sur 16 bits).

Bien entendu, la configuration des figures 5A et 5B - qui implique une reconstruction des composantes colorées par segments de 5 pixels - est donnée uniquement à titre d'exemple et la généralisation de la méthode à d'autres configurations ne pose pas de difficulté significative.

Des variantes de cette méthode sont possibles. Par exemple une autre approche pour déterminer la luminance des pixels colorés en s'aidant à la fois de pixels colorés proches (situés à une certaine distance dépendant du motif des pixels colorés en question) et des pixels panchromatiques voisins reconstitués, consiste à utiliser des fonctions non-linéaires qui approchent la distribution des pixels colorés en se servant, par exemple, d'une approximation polynomiale (et plus généralement d'une approximation d'une fonction non-linéaire de surface spatiale) des pixels panchromatiques avoisinants. L'avantage de ces fonctions non-linéaires mono-axes ou au contraire bi-axes surfaciques est qu'elles prennent en compte la distribution des pixels colorés à une échelle plus grande que les pixels colorés les plus proches du pixel que l'on veut reconstruire. Dans ce cadre d'idées, on peut aussi utiliser des fonctions plus générales de diffusion de valeurs qui exploitent les gradients locaux et les sauts brusques apparaissant dans la valeur de luminance des pixels panchromatiques. Quelle que soit la méthode utilisée, le principe reste le même : exploiter les pixels panchromatiques qui sont en plus grand nombre que les pixels colorés, et la loi de variation de ceux-ci pour reconstruire les pixels colorés.

Alors que la méthode de la loi monochrome implique une approche à 2 passes successives mono-axes, l'utilisation de fonctions surfaciques ou des équations de diffusion permet de procéder par une approche monopasse pour reconstruire les pixels colorés.

A ce stade du traitement on dispose d'une image panchromatique pleine bande, $IM_{PB}$, et de deux ensembles de trois images monochromatiques pleine bande ($IR_{PB}$, $IV_{PB}$, $IB_{PB}$) et ($IR^*_{PB}$, $IV^*_{PB}$, $IB^*_{PB}$). Comme cela a été évoqué plus haut, aucune de ces images n'est directement exploitable. Toutefois, une image couleur en lumière visible $I_{VIS}$ peut être obtenue en combinant les images pleine bande du premier ensemble ($IR_{PB}$, $IV_{PB}$, $IB_{PB}$) et l'image panchromatique pleine bande $IM_{PB}$ par l'intermédiaire d'une matrice de colorimétrie 3x4, MCol1. Plus précisément, la composante rouge IR de l'image visible $I_{VIS}$ est donnée par une combinaison linéaire de $IR_{PB}$, $IV_{PB}$, $IB_{PB}$ et $IM_{PB}$ avec des coefficients $a_{11}$, $a_{12}$, $a_{13}$ et $a_{14}$. De même la composante verte IV est donnée par une combinaison linéaire de $IR_{PB}$, $IV_{PB}$, $IB_{PB}$ et $IM_{PB}$ avec des coefficients $a_{21}$, $a_{22}$, $a_{23}$ et $a_{24}$, et la composante bleue IB est donnée par une combinaison linéaire de $IM_{PB}$, $IV_{PB}$, $IB_{PB}$ et $IR_{PB}$ avec des coefficients $a_{31}$, $a_{32}$, $a_{33}$ et $a_{34}$. Cela est illustré par la figure 6A.

Ensuite, l'image visible $I_{VIS}$ peut être améliorée par une opération de balance des blancs, conventionnelle, pour tenir compte de la différence d'éclairement de la scène par rapport à celle ayant servi à établir les coefficients de la matrice de colorimétrie.

De même, une image dans le proche infrarouge $I_{PIR}$ peut être obtenue en combinant les images pleine bande du deuxième ensemble ($IR_{PB}^*$, $IV_{PB}^*$, $IB_{PB}^*$) et l'image panchromatique pleine bande $IM_{PB}$ par l'intermédiaire d'une deuxième matrice de colorimétrie 1x4, MCol2. En d'autres termes l'image dans le proche infrarouge $I_{PIR}$ est donnée par une combinaison linéaire de $IV_{PB}^*$, $IB_{PB}^*$, $IR_{PB}^*$ et $IR_{PB}$ avec des coefficients $a_{41}$, $a_{42}$, $a_{43}$ et $a_{44}$. Cela est illustré par la figure 6B.

Si plusieurs types de pixels présentent des sensibilités spectrales différentes dans le proche infrarouge, il est possible d'obtenir une pluralité d'images dans le proche infrarouge différentes, correspondant à $N_{PIR}$ sous-bandes spectrales différentes (avec $N_{PIR} > 1$). Dans ce cas, la deuxième matrice de colorimétrie MCol2 devient une matrice $N_{PIR} \times (N_{PIR}+3)$, $N_{PIR}$ étant le nombre d'images dans le proche infrarouge que l'on souhaite obtenir. Le cas traité précédemment est le cas particulier où $N_{PIR}=1$.

Ensuite, l'image dans le proche infrarouge $I_{PIR}$ peut être améliorée par une opération de filtrage spatial, conventionnelle. Cette opération peut être par exemple une opération de rehaussement de contours associée ou non à un filtrage adaptatif du bruit (parmi les techniques possibles de rehaussement de contours, on peut citer l'opération consistant à passer sur l'image un filtre de convolution passe-haut).

Les matrices MCol1 et MCol2 sont en fait des sous-matrices d'une même matrice de colorimétrie « A », de dimensions 4x4 dans le cas particulier où $N_{PIR}=1$ et où il y a 3 types de pixels colorés, qui n'est pas utilisée en tant que telle.

La taille des matrices de colorimétrie doit être modifiée si le capteur matriciel présente plus de trois types différents de pixels colorés. A titre d'exemple, comme pour les $N_{PIR}$ pixels ayant des sensibilités spectrales différentes dans l'infrarouge, il peut y avoir $N_{VIS}$ (avec $N_{VIS} \geq 3$) types de pixels sensibles à différentes sous-bandes dans le visible en plus des pixels non filtrés panchromatiques. Ces $N_{VIS}$ types de pixels peuvent par ailleurs présenter des sensibilités spectrales différentes dans le proche infrarouge pour permettre l'acquisition de $N_{PIR}$ images PIR. En supposant qu'il n'y a pas de pixels sensibles uniquement dans l'infrarouge, la matrice de colorimétrie Mcol1 est alors de dimension $3 \times (N_{VIS}+1)$.

Par ailleurs, l'image visible monochromatique $I_{BNL}$ peut être obtenue en combinant les images pleine bande du deuxième ensemble ($IV_{PB}^*$, $IB_{PB}^*$, $IR_{PB}^*$) et l'image panchromatique pleine bande $IM_{PB}$ par l'intermédiaire d'une deuxième matrice de colorimétrie 1x4, MCol3. En d'autres termes l'image $I_{BNL}$ est donnée par une combinaison linéaire de $IR_{PB}^*$, $IV_{PB}^*$, $IB_{PB}^*$ et $IM_{PB}$ avec des coefficients $\tilde{a}_{41}$, $\tilde{a}_{42}$, $\tilde{a}_{43}$, $\tilde{a}_{44}$ qui forment la dernière ligne d'une autre matrice de colorimétrie 4x4 « $\tilde{A}$ », qui n'est pas non plus utilisée en tant que telle. Cela est illustré par la figure 6C.

L'image $I_{BNL}$ peut à son tour être améliorée par une opération de filtrage spatial, conventionnelle.

Les matrices de colorimétrie A et $\tilde{A}$ peuvent être obtenues par une méthode de calibration. Celle-ci consiste par exemple à utiliser une mire sur laquelle différentes peintures réfléchissantes dans le visible et le PIR ont été déposées, d'éclairer le dispositif par un éclairement maitrisé et de comparer les valeurs théoriques de luminance que devraient avoir ces peintures dans le visible et le PIR avec celles mesurées, en utilisant une matrice de colorimétrie 4x4 dont on adapte au mieux les coefficients par un moindre carré. La matrice de colorimétrie peut aussi être améliorée en pondérant les couleurs que l'on veut faire ressortir de manière privilégiée ou en rajoutant des mesures faites sur des objets naturels présents dans la scène. La méthode proposée (exploitation du PIR en plus de la couleur, utilisation de matrice 4x4, utilisation de peintures différentes émettant à la fois dans le visible et le PIR) diffère des méthodes conventionnelles cantonnées à la couleur, exploitant une matrice 3x3 et une mire conventionnelle telle que le « X-Rite checkerboard », ou la matrice de Macbeth.

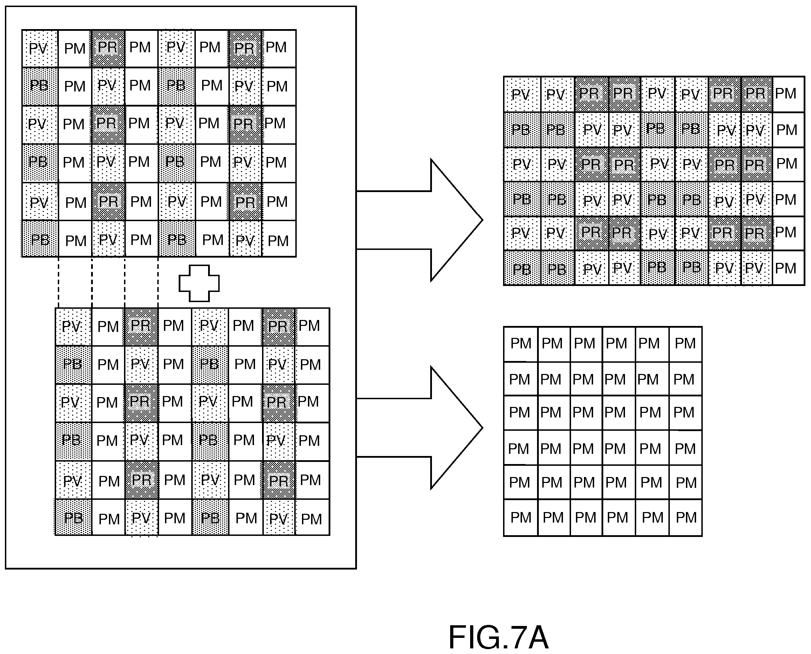

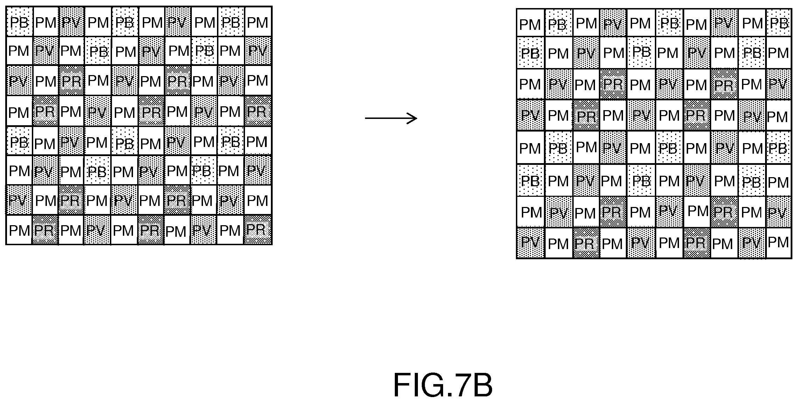

Les figures 7A et 7B illustrent une possible amélioration de l'invention, mettant en œuvre un micro-balayage du capteur. Le micro-balayage consiste en un déplacement périodique (oscillation) du capteur matriciel dans le plan image, ou de l'image par rapport au capteur. Ce déplacement peut être obtenu grâce à un actionneur piézoélectrique ou de type moteur à courant continu, agissant sur le capteur matriciel ou sur au moins un élément optique de formation d'image. Plusieurs (généralement deux) acquisitions d'images sont effectuées au cours de ce déplacement, ce qui permet d'améliorer l'échantillonnage spatial et donc de faciliter la reconstruction des images. Bien entendu, cela nécessite une cadence d'acquisition plus élevée que si on n'avait pas recours au micro-balayage.

Dans l'exemple de la figure 7A, le capteur matriciel CM présente une structure particulière ; une colonne sur deux est constituée de pixels panchromatiques PM, une sur quatre, d'une alternance de pixels verts PV et bleus PB, et une sur quatre d'une alternance de pixels rouges PR et verts PV. Le micro-balayage s'effectue au moyen d'une oscillation d'amplitude égale à la largeur d'un pixel, dans une direction perpendiculaire à celle des colonnes. On peut voir que la place occupée par une ligne « panchromatique » lorsque le capteur se trouve à une extrémité de son déplacement est occupée par une ligne « colorée » lorsqu'il se trouve à l'extrémité opposée, et réciproquement. La cadence d'acquisition d'image est plus élevée que celle réalisée sans microbalayage (par exemple à fréquence double de la fréquence obtenue sans micro-balayage) ceci pour pouvoir rajouter des informations aux images acquises sans micro-balayage.

En prenant l'exemple d'une fréquence d'acquisition double, à partir de deux images acquises en correspondance de deux positions extrêmes opposées du capteur (partie gauche de la figure 7A) il est possible de reconstruire (partie droite de la figure) :

- une image en couleurs formée par la répétition d'un motif de quatre pixels - deux verts agencés selon une diagonale, un bleu et un rouge (matrice dite « de Bayer »), formée par des pixels reconstruits ayant une forme allongée dans la direction du déplacement avec un rapport de forme de 2 ; et
- une image panchromatique « pleine », directement exploitable sans besoin d'interpolation ;

ces deux images reconstruites étant acquises à une cadence deux fois moindre que la fréquence d'acquisition.

En effet, le micro-balayage complète les informations de pixels panchromatiques et colorés, et les traitements présentés dans le cadre de la présente invention peuvent directement s'appliquer sur les motifs engendrés à partir du détecteur avant micro-balayage et des motifs supplémentaires obtenus après sous-balayage, il n'est donc pas indispensable d'utiliser un motif spécifique comme présenté en figure 7A, celui-ci pouvant cependant s'appliquer avec des algorithmes simplifiés. Par ailleurs, le micro-balayage peut s'effectuer selon deux axes et/ou avoir une amplitude supérieure à la largeur d'un pixel.

A titre d'exemple, la figure 7B illustre l'application du micro-balayage au capteur CM de la figure 3A. Dans cet exemple de configuration éparse, de type 1/8, le micro-balayage implique le recouvrement de tous les pixels panchromatiques, l'ajout de 2 sous-motifs bleus, 2 sous-motifs rouges et 4 sous-motifs verts qui se superposent aux endroits préalablement panchromatiques et qui permettent au total d'appliquer les traitements sur 2 fois plus de sous-motifs qu'initialement. Dans des configurations éparses plus complexes (1/N avec N>=16), on peut généraliser le micro-balayage à M positions suivant les deux dimensions de la matrice simultanément, et gagner un facteur M sur le nombre de sous-motifs.

Jusqu'à présent, seul le cas d'un capteur matriciel comprenant exactement quatre types de pixels - rouges, verts, bleus et panchromatiques - a été considéré, mais il ne s'agit pas là d'une limitation essentielle. Il est possible d'utiliser trois types de pixels colorés, voire davantage, présentant des courbes de sensibilité différentes de celles illustrées sur la figure 1B. En outre, il est possible d'utiliser un cinquième type de pixel, sensible uniquement au rayonnement dans le proche infrarouge. A titre d'exemple, la figure 8 représente un capteur matriciel dans lequel un pixel sur quatre est panchromatique (référence PM), un pixel sur quatre est sensible uniquement au proche infrarouge (PI), un pixel sur quatre est vert (PV), un pixel sur huit est rouge (PR) et un pixel sur huit est bleu (PB).

Les signaux issus des pixels du cinquième type peuvent être utilisés de différentes façons. Par exemple il est possible de reconstruire, par la méthode « intra-canal » des figures 4A - 4D, une image dans le proche infrarouge, désignée par exemple par $I_{PIR}{}^{D}$ (l'exposant « D » signifiant qu'il s'agit d'une image acquise « directement »), qui peut être moyennée avec l'image $I_{PIR}$ obtenue par application de la matrice de colorimétrie MCol2 aux images $IR_{PB}{}^{*}$, $IV_{PB}{}^{*}$, $IB_{PB}{}^{*}$ et $IM_{PB}$. Il est également possible d'utiliser une matrice de colorimétrie MCol2 de dimensions 1x5 et d'obtenir l'image dans le proche infrarouge $I_{PIR}$ par une combinaison linéaire de $IR_{PB}{}^{*}$, $IV_{PB}{}^{*}$, $IB_{PB}{}^{*}$, $IM_{PB}$ et $I_{PIR}{}^{D}$ avec des coefficients matriciels $a_{41}$, $a_{42}$, $a_{43}$, $a_{44}$ et $a_{45}$. L'image $I_{PIR}{}^{D}$ peut aussi être utilisée pour calibrer la matrice de colorimétrie MCol1 qui contient alors une colonne de plus et devient de taille $3x(N_{VIS}+2)$ : chaque composante rouge, verte, bleue reproduite s'exprime alors en fonction des $N_{VIS}$ plans reproduits en pleine bande, du plan panchromatique reconstruit et du plan PIR reconstruit à partir des pixels $I_{PIR}{}^{D}$.

La figure 9A est une image composite d'une scène, observée en lumière visible. La partie de gauche de l'image, $I_{VIS}$, a été obtenue conformément à l'invention, en utilisant le capteur matriciel « épars » de la figure 3. La partie droite, l'$_{VIS}$ a été obtenue par une méthode classique, utilisant un capteur non épars. La qualité des deux images est comparable.

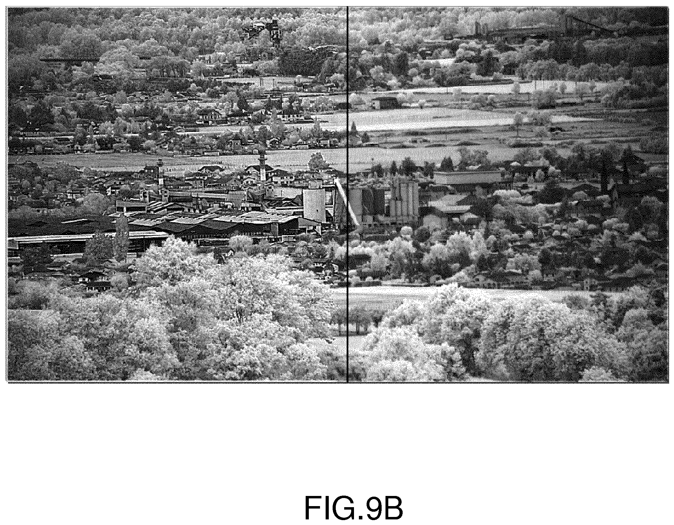

La figure 9B est une image composite de la même scène, observée dans le proche infrarouge. La partie de gauche de l'image, $I_{PIR}$, a été obtenue conformément à l'invention, en utilisant le capteur matriciel « épars » de la figure 3. La partie droite, l'$_{PIR}$ a été obtenue en utilisant une caméra PIR avec un capteur non épars. Les images sont de qualité comparable, mais l'image $I_{PIR}$ obtenue conformément à l'invention est plus lumineuse grâce à l'utilisation d'un capteur épars.

**Revendications**

1. Système d'acquisition d'images (SAI) comprenant :

- un capteur matriciel (CM) comprenant un agencement bidimensionnel de pixels, chaque pixel étant adapté pour générer un signal électrique représentatif de l'intensité lumineuse en un point d'une image optique (IO) d'une scène (SC) ; et
- un circuit de traitement de signaux (CTS) configuré pour traiter les signaux électriques générés par lesdits pixels de manière à générer des images numériques ($I_{VIS}$, $I_{PIR}$) de ladite scène ;

dans lequel ledit capteur matriciel comprend un arrangement bidimensionnel :

- de pixels, dits colorés, d'au moins un premier type (PV), sensibles à la lumière visible dans une première plage spectrale; un deuxième type (PB), sensibles à la lumière visible dans une deuxième plage spectrale différente de la première ; et un troisième type (PR), sensibles à la lumière visible dans une troisième plage spectrale différente de la première et de la deuxième, une combinaison des plages spectrales des différents types de pixels colorés reconstituant l'ensemble du spectre visible ;
- et de pixels, dits panchromatiques, (PM), sensibles à l'ensemble du spectre visible,

au moins les pixels panchromatiques étant également sensibles au proche infrarouge ;
**caractérisé en ce que** ledit circuit de traitement de signaux est configuré pour :

- reconstruire un premier ensemble d'images monochromatiques ($IV_{PB}$, $IB_{PB}$, $IR_{PB}$) à partir des signaux électriques générés par les seuls pixels colorés ;
- reconstruire une image panchromatique ($IM_{PB}$) à partir des signaux électriques générés par les pixels panchromatiques ;
- reconstruire un deuxième ensemble d'images monochromatiques ($IV^*_{PB}$, $IB^*_{PB}$, $IR^*_{PB}$) à partir des signaux électriques générés par les pixels colorés, et de ladite image panchromatique, ces images contenant des contributions provenant d'une composante infrarouge de l'image optique ;
- reconstruire une image en couleurs ($I_{VIS}$), sensiblement exempte de contributions provenant d'une composante infrarouge de l'image optique, par application d'une première matrice de colorimétrie (MCol1) aux images monochromatiques du premier ensemble et à ladite image panchromatique ;
- reconstruire une image dans le proche infrarouge ($I_{PIR}$) par application d'une deuxième matrice (MCol2) de colorimétrie au moins aux images monochromatiques du deuxième ensemble et à ladite image panchromatique ; et
- fournir en sortie ladite image en couleurs et ladite ou au moins une dite image dans le proche infrarouge.

2. Système d'acquisition d'images selon la revendication 1, dans lequel lesdits pixels colorés comprennent uniquement les pixels desdits premier, deuxième et troisième type, qui sont également sensibles au proche infrarouge.

3. Système d'acquisition d'images selon la revendication 1 ou 2, dans lequel les pixels d'un parmi le premier, le deuxième et le troisième type sont sensibles à la lumière verte, ceux d'un autre parmi le premier, le deuxième et le troisième type sont sensibles à la lumière bleue et ceux du type restant parmi le premier, le deuxième et le troisième type sont sensibles à la lumière rouge.

4. Système d'acquisition d'images selon l'une des revendications précédentes dans lequel ledit capteur matriciel est de type épars, plus d'un quart et de préférence au moins la moitié de ses pixels étant panchromatiques.

5. Système d'acquisition d'images selon l'une des revendications précédentes, dans lequel ledit circuit de traitement de signaux est configuré pour reconstruire les images monochromatiques dudit premier ensemble par application d'une méthode comprenant les étapes suivantes :

- déterminer l'intensité lumineuse associée à chaque pixel dudit premier type et reconstruire une première image monochromatique ($IV_{PB}$) dudit premier ensemble par interpolation desdites intensités lumineuses ;
- déterminer l'intensité lumineuse associée à chaque pixel coloré des autres types, et en soustraire une valeur représentative de l'intensité associée à un pixel correspondant de ladite première image monochromatique ;
- reconstruire de nouvelles images monochromatiques ($IB'_{PB}$, $IR'_{PB}$) par interpolation des valeurs d'intensité lumineuse des pixels colorés respectifs desdits autres types, auxquelles ont été soustraites lesdites valeurs représentatives de l'intensité associée à un pixel correspondant de ladite première image monochromatique, puis combiner ces nouvelles images reconstruites avec ladite première image monochromatique ($IV_{PB}$) pour obtenir des images monochromatiques finales respectives ($IB_{PB}$, $IR_{PB}$) dudit premier ensemble.

6. Système d'acquisition d'images selon l'une des revendications précédentes, dans lequel ledit circuit de traitement de signaux est configuré pour reconstruire ladite image panchromatique par interpolation des signaux électriques générés par les pixels panchromatiques.

**7.** Système d'acquisition d'images selon l'une des revendications précédentes, dans lequel ledit circuit de traitement de signaux est configuré pour reconstruire les images monochromatiques dudit deuxième ensemble en calculant le niveau de luminance de chaque pixel de chaque dite image par application d'une fonction linéaire, définie localement, à la luminance du pixel correspondant dans l'image panchromatique.

**8.** Système d'acquisition d'images selon l'une des revendications 1 à 6, dans lequel ledit circuit de traitement de signaux est configuré pour reconstruire les images monochromatiques dudit deuxième ensemble en calculant le niveau de luminance de chaque pixel de chaque dite image au moyen d'une fonction non-linéaire des niveaux de luminance d'une pluralité de pixels de l'image panchromatique dans un voisinage du pixel de laite image panchromatique correspondant audit pixel de ladite image du deuxième ensemble et/ou de l'intensité lumineuse d'une pluralité de pixels colorés .

**9.** Système d'acquisition d'images selon l'une des revendications précédentes, dans lequel ledit capteur matriciel est constitué d'une répétition périodique de blocs contenant des répartitions pseudo-aléatoires de pixels des différents types et dans lequel ledit circuit de traitement de signaux est configuré pour :

- extraire des motifs réguliers de pixels de mêmes types dudit capteur matriciel ; et
- reconstruire lesdits premier ensemble et deuxième ensemble d'images monochromatiques en traitant de manière parallèle lesdits motifs réguliers de pixels de mêmes types.

**10.** Système d'acquisition d'images selon l'une des revendications précédentes, dans lequel ledit circuit de traitement de signaux est également configuré pour reconstruire une image monochromatique à bas niveau de luminosité par application d'une troisième matrice (MCol3) de colorimétrie au moins aux images monochromatiques du deuxième ensemble et à ladite image panchromatique.

**11.** Système d'acquisition d'images selon l'une des revendications précédentes, dans lequel ledit capteur matriciel (CM) comprend également un arrangement bidimensionnel de pixels (PI) uniquement sensibles au proche infrarouge, et dans lequel ledit circuit de traitement de signaux est configuré pour reconstruire ladite image dans le proche infrarouge (I$_{PIR}$) également à partir des signaux électriques générés par ces pixels.

**12.** Système d'acquisition d'images selon l'une des revendications précédentes comprenant également un actionneur pour produire un déplacement périodique relatif entre le capteur matriciel et l'image optique, dans lequel le capteur matriciel est adapté pour reconstruire lesdits premier et deuxième ensembles d'images monochromatique et ladite image panchromatique à partir de signaux électriques générés par les pixels du capteur matriciel en correspondance d'une pluralité de positions relatives distinctes du capteur matriciel et de l'image optique.

**13.** Système d'acquisition d'images selon l'une des revendications précédentes, dans lequel ledit circuit de traitement de signaux est réalisé à partir d'un circuit logique programmable.

**14.** Caméra bi-spectrale visible - proche infrarouge (CBS) comprenant :

- un système d'acquisition d'images (SAI) selon l'une des revendications précédentes ; et
- un système optique (SO) adapté pour former une image optique (IO) d'une scène (SC) sur un capteur matriciel (CM) d'un tel système d'acquisition d'images, sans filtrage du proche infrarouge.

**15.** Procédé d'acquisition simultanée d'images en couleurs et dans le proche infrarouge par utilisation d'une caméra bi-spectrale selon la revendication 14.

**Patentansprüche**

**1.** Bilderfassungssystem (SAI) umfassend :

- einen Matrixsensor (CM) umfassend eine zweidimensionale Pixelanordnung, wobei jedes Pixel angepasst ist, ein elektrisches Signal zu erzeugen, das für die Lichtintensität an einem Punkt eines optischen Bildes (IO) einer Szene (SC) repräsentativ ist; und
- eine Signalverarbeitungsschaltung (CTS) die konfiguriert ist, um die von den Pixeln erzeugten elektrischen Signale zu verarbeiten, um digitale Bilder (I$_{VIS}$, I$_{PIR}$) der Szene zu erzeugen;

wobei der Matrixsensor eine zweidimensionale Anordnung aus folgendem umfasst:

- sogenannten farbigen Pixeln, von mindestens einem ersten Typ (PV), die für sichtbares Licht in einem ersten Spektralband empfindlich sind, einem zweiten Typ (PB), die für sichtbares Licht in einem zweiten Spektralband empfindlich sind, das sich von der ersten unterscheidet, und einem dritten Typ (PR), die für sichtbares Licht in einem dritten Spekralband empfindlich sind, das sich von dem ersten und dem zweiten unterscheidet, wobei eine Kombination der Spektralbände der verschiedenen Typen von farbigen Pixeln die Gesamtheit des sichtbaren Spektrums nachstellt;

- und sogenannte panchromatische Pixel (PM), die für die Gesamtheit des sichtbaren Spektrums empfindlich sind,

wobei mindestens die panchromatischen Pixel ebenfalls für das nahe Infrarot empfindlich sind; **dadurch gekennzeichnet, dass** die Signalverarbeitungsschaltung konfiguriert ist zum:

- Rekonstruieren eines ersten Satzes monochromatischer Bilder ($IV_{PB}$, $IB_{PB}$, $IR_{RB}$) aus den ausschließlich von den farbigen Pixeln erzeugten elektrischen Signalen;
- Rekonstruieren eines panchromatischen Bildes ($IM_{PB}$) aus den von den panchromatischen Pixeln erzeugten elektrischen Signalen;
- Rekonstruieren eines zweiten Satzes von monochromatischen Bildern ($IV^*_{PB}$, $IB^*_{PB}$, $IR^*_{PB}$) aus den von den farbigen Pixeln erzeugten elektrischen Signalen und aus dem panchromatischen Bild, wobei diese Bilder Beiträge aus einer Infrarot-Lichtkomponente des optischen Bilden enthalten;
- Rekonstruieren eines Farbbildes ($I_{VIS}$), das im Wesentlichen frei von Beiträgen aus einer Infrarotkomponente des optischen Bildes ist, durch Aufbringen einer ersten Farbmessmatrix (Mcol1) auf die monochromatischen Bilder des ersten Satzes und auf das panchromatische Bild;
- Rekonstruieren eines Bildes im nahen Infrarot ($I_{PIR}$) durch Aufbringen einer zweiten Farbmessmatrix (Mcol2) auf mindestens die monochromatischen Bilder des zweiten Satzes und auf das panchromatische Bild; und
- Ausgeben des Farbbildes und des oder mindestens eines Bildes im nahen Infrarot.

2. Bilderfassungssystem nach Anspruch 1, wobei die farbigen Pixel nur die Pixel des ersten, zweiten und dritten Typs umfassen, die ebenfalls für das nahe Infrarot empfindlich sind.

3. Bilderfassungssystem nach Anspruch 1 oder 2, wobei die Pixel eines von dem ersten, zweiten und dritten Typ für grünes Licht empfindlich sind, die Pixel eines anderen von dem ersten, zweiten und dritten Typ für blaues Licht und die Pixel des verbleibenden Typs von dem ersten, zweiten und dritten Typ für rotes Licht empfindlich sind.

4. Bilderfassungssystem nach einem der vorhergehenden Ansprüche, wobei der Matrixsensor vom spärlichen Typ ist, wobei mehr als ein Viertel und vorzugsweise mindestens die Hälfte seiner Pixel panchromatisch sind.

5. Bilderfassungssystem nach einem der vorhergehenden Ansprüche, wobei die Signalverarbeitungsschaltung konfiguriert ist, um die monochromatischen Bilder des ersten Satzes durch Anwendung eines Verfahrens zu rekonstruieren, das die folgenden Schritte umfasst:

- Bestimmen der Lichtintensität, die jedem Pixel des ersten Typs zugeordnet ist, und Rekonstruieren eines ersten monochromatischen Bildes ($IV_{PB}$) des ersten Satzes durch Interpolation der Lichtintensitäten;
- Bestimmen der Lichtintensität, die jedem farbigen Pixel der anderen Typen zugeordnet ist, und daraus Subtrahieren eines Wertsdaraus einen Wert subtrahieren, der für die Intensität repräsentativ ist, die einem entsprechenden Pixel des ersten monochromatischen Bildes zugeordnet ist;
- Rekonstruktion neuer monochromatischer Bilder ($IB'_{PB}$, $IR'_{PB}$) durch Interpolation der Lichtintensitätswerte der jeweiligen farbigen Pixel der anderen Typen, von denen die Werte subtrahiert wurden, die für die Intensität repräsentativ sind, die einem entsprechenden Pixel des ersten monochromatischen Bildes zugeordnet ist, dann Kombinieren dieser neuen rekonstruierten Bilder mit dem ersten monochromatischen Bild ($IV_{PB}$), um entsprechende endgültige monochromatische Bilder ($IB_{PB}$, $IR_{PB}$) des ersten Satzes zu erhalten.

6. Bilderfassungssystem nach einem der vorhergehenden Ansprüche, wobei die Signalverarbeitungsschaltung konfiguriert ist, um das panchromatische Bild durch Interpolation der von den panchromatischen Pixeln erzeugten elektrischen Signale zu rekonstruieren.

7. Bilderfassungssystem nach einem der vorhergehenden Ansprüche, wobei die Signalverarbeitungsschaltung konfiguriert ist, um die monochromatischen Bilder des zweiten Satzes zu rekonstruieren, indem der Luminanzpegel jedes Pixels jedes Bildes durch Anwendung einer lokal definierten linearen Funktion berechnet wird, auf die Luminanz des entsprechenden Pixels im panchromatischen Bild.

8. Bilderfassungssystem nach einem der Ansprüche 1 bis 6, wobei die Signalverarbeitungsschaltung konfiguriert ist, um die monochromatischen Bilder des zweiten Satzes zu rekonstruieren, indem der Luminanzpegel jedes Pixels jedes Bildes berechnet wird mittels einer nichtlinearen Funktion der Luminanzpegel einer Vielzahl von Pixeln des panchromatischen Bildes in einer Nachbarschaft des Pixels des panchromatischen Bildes das dem Pixel des Bildes des zweiten Satzes und/oder der Lichtintensität einer Vielzahl von farbigen Pixeln entspricht.

9. Bilderfassungssystem nach einem der vorhergehenden Ansprüche, wobei der Matrixsensor aus einer periodischen Wiederholung von Blöcken besteht, die pseudozufällige Verteilungen von Pixeln der verschiedenen Typen enthalten, und wobei die Signalverarbeitungsschaltung konfiguriert ist, um:

- regelmäßige Muster von Pixeln des gleichen Typs aus dem Matrixsensor zu extrahieren; und
- den ersten und den zweiten Satz monochromatischer Bilder durch parallele Verarbeitung der regulären Muster von Pixeln des gleichen Typs zu rekonstruieren.

10. Bilderfassungssystem nach einem der vorhergehenden Ansprüche, wobei die Signalverarbeitungsschaltung auch konfiguriert ist, um ein monochromatisches Bild mit niedrigem Helligkeitsniveau durch Aufbringen einer dritten Farbmessmatrix (MCol3) mindestens auf die monochromatischen Bilder des zweiten Satzes und auf das panchromatische Bild zu rekonstruieren.

11. Bilderfassungssystem nach einem der vorhergehenden Ansprüche, wobei der Matrixsensor (CM) auch eine zweidimensionale Anordnung von Pixeln (PI) umfasst, die nur für das nahe Infrarot empfindlich sind, und wobei die Signalverarbeitungsschaltung konfiguriert ist, um das Bild im nahen Infrarot ($I_{PIR}$) auch von den von diesen Pixeln erzeugten elektrischen Signalen zu rekonstruieren.

12. Bilderfassungssystem nach einem der vorhergehenden Ansprüche, ebenfalls umfassend einen Aktuator zum Erzeugen einer relativen periodischen Verschiebung zwischen dem Matrixsensor und dem optischen Bild, wobei der Matrixsensor angepasst ist, um den ersten und den zweiten Satz von monochromatischen Bildern und das panchromatische Bild zu rekonstruieren, aus von den Pixeln des Matrixsensors erzeugten elektrischen Signalen, entsprechend einer Vielzahl von unterschiedlichen relativen Positionen des Matrixsensors und des optischen Bildes.

13. Bilderfassungssystem nach einem der vorhergehenden Ansprüche, wobei die Signalverarbeitungsschaltung aus einer programmierbaren Logikschaltung erzeugt wird.

14. Sichtbare Nahinfrarot-Bispektralkamera (CBS), umfassend:

- ein Bilderfassungssystem (SAI), nach einem der vorhergehenden Ansprüche; und
- ein optisches System (SO), das angepasst ist, um ein optisches Bild (IO) einer Szene (SC) auf einem Matrixsensor (CM) eines solchen Bilderfassungssystems zu erzeugen, ohne das nahe Infrarot zu filtern.

15. Verfahren zur gleichzeitigen Erfassung von Farbbildern und im nahen Infrarot unter Verwendung einer bispektralen Kamera nach Anspruch 14.

**Claims**

1. An image acquisition system (SAI) comprising:

- a matrix sensor (CM) comprising a two-dimensional arrangement of pixels, each pixel being adapted to generate an electrical signal representative of the light intensity at a point of an optical image (IO) of a scene (SC); and
- a signal processing circuit (CTS) configured to process the electrical signals generated by said pixels so as to generate digital images ($I_{VIS}$, $I_{PIR}$) of said scene;

wherein said matrix sensor comprises a two-dimensional arrangement:

- of so-called colored pixels of at least one first type (PV), sensitive to visible light in a first spectral band; a second type (PB), sensitive to visible light in a second spectral band different from the first; and a third type (PR), sensitive to visible light in a third spectral band different from the first and the second, a combination of the spectral bands of the different types of colored pixels reconstituting all of the visible spectrum;
- and of so-called panchromatic pixels (PM), sensitive to all the visible spectrum,

at least the panchromatic pixels being also sensitive to the near-infrared;
**characterized in that** said signal processing circuit is configured to:

- reconstruct a first set of monochromatic images ($IV_{PB}$, $IB_{PB}$, $IR_{PB}$) from the electrical signals generated exclusively by the colored pixels;
- reconstruct a panchromatic image ($IM_{PB}$) from the electrical signals generated by the panchromatic pixels;
- reconstruct a second set of monochromatic images ($IV^*_{PB}$, $IB^*_{PB}$, $IR^*_{PB}$) from the electrical signals generated by the colored pixels, and from said panchromatic image;
- reconstruct a color image ($I_{VIS}$), substantially free of contributions originating from an infrared component of the optical image, by application of a first colorimetry matrix (MCol1) to the monochromatic images of the first set and to said panchromatic image;

- reconstruct at least one image in the near-infrared ($I_{PIR}$) by application of a second colorimetry matrix (MCol2) at least to the monochromatic images of the second set and to said panchromatic image; and

- supply as output said color image and said or at least one said image in the near-infrared.

2. The image acquisition system as claimed in claim 1, wherein said colored pixels comprise only the pixels of said first, second and third types, which are also sensitive to the near-infrared.

3. The image acquisition system as claimed in claim 1 or 2, wherein the pixels of one out of the first, the second and the third types are sensitive to green light, those of another out of the first, the second and the third types are sensitive to blue light and those of the remaining type out of the first, the second and the third types are sensitive to red light.

4. The image acquisition system as claimed in one of the preceding claims, wherein said matrix sensor is of sparse type, more than a quarter and preferably at least half of its pixels being panchromatic.

5. The image acquisition system as claimed in one of the preceding claims, wherein said signal processing circuit is configured to reconstruct the monochromatic images of said first set by application of a method comprising the following steps:

- determining the light intensity associated with each pixel of said first type and reconstructing a first monochromatic image ($IV_{PB}$) of said first set by interpolation of said light intensities;
- determining the light intensity associated with each colored pixel of the other types, and subtracting therefrom a value representative of the intensity associated with a corresponding pixel of said first monochromatic image;
- reconstructing new monochromatic images ($IB'_{PB}$, $IR'_{PB}$) by interpolation of the light intensity values of the respective colored pixels of said other types, from which have been subtracted said values representative of the intensity associated with a corresponding pixel of said first monochromatic image, then combining these new reconstructed images with said first monochromatic image ($IV_{PB}$) to obtain respective final monochromatic images ($IB_{PB}$, $IR_{PB}$) of said first set.

6. The image acquisition system as claimed in one of the preceding claims, wherein said signal processing circuit is configured to reconstruct said panchromatic image by interpolation of the electrical signals generated by the panchromatic pixels.

7. The image acquisition system as claimed in one of the preceding claims, wherein said signal processing circuit is configured to reconstruct the monochromatic images of said second set by computing the luminance level of each pixel of each said image by application of a linear function, defined locally, to the luminance of the corresponding pixel in the panchromatic image.

8. The image acquisition system as claimed in one of claims 1 to 6, wherein said signal processing circuit is configured to reconstruct the monochromatic images of said second set by computing the luminance level of each pixel of each said image by means of a non-linear function of the luminance levels of a plurality of pixels of the panchromatic image in a neighborhood of the pixel of said panchromatic image corresponding to said pixel of said image of the second set and/or of the light intensity of a plurality of colored pixels.

9. The image acquisition system as claimed in one of the preceding claims, wherein said matrix sensor is composed of a periodic repetition of blocks containing pseudorandom distributions of pixels of the different types and wherein said signal processing circuit is configured to:

- extract regular patterns of pixels of the same types from said matrix sensor; and
- reconstruct said first set and second set of monochromatic images by parallel processing of said regular patterns of pixels of the same types.

10. The image acquisition system as claimed in one of the preceding claims, wherein said signal processing circuit is also configured to reconstruct a monochromatic image with low brightness level by application of a third colorimetry matrix (MCol3) at least to the monochromatic images of the second set and to said panchromatic image.

11. The image acquisition system as claimed in one of the preceding claims, wherein said matrix sensor (CM) also comprises a two-dimensional arrangement of pixels (PI) only sensitive to the near-infrared, and wherein said signal processing circuit is configured to reconstruct said image in the near-infrared ($I_{PIR}$) also from the electrical signals generated by these pixels.

12. The image acquisition system as claimed in one of the preceding claims, also comprising an actuator for producing a relative periodic displacement between the matrix sensor and the optical image, wherein the matrix sensor is adapted to reconstruct said first and second sets of monochromatic images and said panchromatic image from electrical signals generated by the pixels of the matrix sensor corresponding to a plurality of distinct relative positions of the matrix sensor and of the optical image.

13. The image acquisition system as claimed in one of the preceding claims, wherein said signal processing circuit is produced from a programmable logic circuit.

14. A visible - near-infrared bispectral camera (CBS) comprising:

    - an image acquisition system (SAI) as claimed in one of the preceding claims; and
    - an optical system (SO) adapted to form an optical image (IO) of a scene (SC) on a matrix sensor (SC) of such an image acquisition system, without filtering of the near-infrared.

15. A method for simultaneous acquisition of images in color and in the near-infrared by use of a bispectral camera as claimed in claim 14.

FIG.1A

VIS
350-700 nm

PIR
800-1100 nm

FIG.1B

Image éparse pleine bande

Extract. sous-motifs $R_{PB}$, $V_{PB}$, $B_{PB}$

Extract. sous-motif Panchromatique$_{PB}$

Reconstruction images $IR_{PB}$ $IV_{PB}$, $IB_{PB}$ Méthode intra-canal

Reconstruction image Panchromatique $IM_{PB}$ Méthode des médianes

Reconstruction images $IR^*_{PB}$ $IV^*_{PB}$, $IB^*_{PB}$ Méthode inter-canaux

Images $IR_{PB}$, $IV_{PB}$, $IB_{PB}$

Image Panchromatique $IM_{PB}$

Images $IR^*_{PB}$, $IV^*_{PB}$, $IB^*_{PB}$

Reconstruction & Colorimétrie

Reconstruction & Colorimétrie

Reconstruction & Colorimétrie

Balance des blancs

Filtrage spatial

Filtrage spatial

Image couleur visible $I_{VIS}$

Image PIR $I_{PIR}$

Image bas niveau de luminosité $I_{BNL}$

FIG.2

FIG.3A

FIG.3B

FIG.4A

SMPV1

IV$_{PB}^1$

SMPV2

IV$_{PB}^2$

SMPV3

Interpolations bilinéaires

Moyenne

IV$_{PB}^3$

IV$_{PB}$

SMPV4

IV$_{PB}^4$

## FIG.4B

SMPR1'=SPR1-IV$_{PB}$   SMPR2'=SPR2-IV$_{PB}$   SMPB1'=SPB1-IV$_{PB}$   SMPB2'=SPB2-IV$_{PB}$

## FIG.4C

FIG.4D

EP 3 387 824 B1

PB

## FIG.5A

## FIG.5B

FIG.6A

FIG.6B

EP 3 387 824 B1

$IR^*_{PB}$

$IB^*_{PB}$

$IV^*_{PB}$

$IM^*_{PB}$

$\widetilde{A}$

$$X \begin{pmatrix} \widetilde{a}_{11} & \widetilde{a}_{12} & \widetilde{a}_{13} & \widetilde{a}_{14} \\ \widetilde{a}_{21} & \widetilde{a}_{22} & \widetilde{a}_{23} & \widetilde{a}_{24} \\ \widetilde{a}_{31} & \widetilde{a}_{32} & \widetilde{a}_{33} & \widetilde{a}_{34} \\ \widetilde{a}_{41} & \widetilde{a}_{42} & \widetilde{a}_{43} & \widetilde{a}_{44} \end{pmatrix} = $$

MCol3

$I_{BNL}$

FIG.6C

FIG.7A

FIG.7B

FIG.8

FIG.9A

FIG.9B

**EP 3 387 824 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 8619143 B
- US 4642678 A

### Littérature non-brevet citée dans la description

- **D. KIKU et al.** Simultaneously Capturing of RGB and Additional Band Images using Hybrid Color Filter Array. *Proc. of SPIE-IS&T Electronic Imaging, SPIE,* 2014, vol. 9023
- **Z. SADEGHIPOOR et al.** Designing Color Filter Arrays for the Joint Capture of Visible and Near-Infrared images. *16th IEEE Conférence on Image Processing,* 2009
- **Z. SADEGHIPOOR et al.** Correlation-Based Joint Acquisition and Demosaicing of Visible and Near-Infrared Images. *18th IEEE Conférence on Image Processing,* 2011
- **Z. SADEGHIPOOR et al.** A Novel Compressive Sensing Approach to Simultaneously Acquire Color and Near Infrared Images on a Single Sensor. *Proc. IEEE International Conférence on Acoustics, Speech and Signal Processing (ICASSP),* 2013
- **D. HERTEL et al.** A low-cost VIS-NIR true color night vision video system based on a wide dynamic range CMOS imager. *IEEE Intelligent Vehicles Symposium,* 2009, 273-278